# FASCICULE DE BREVET EUROPEEN

(11) **EP 0 915 431 B1**
(45) Date de publication et mention de la délivrance du brevet: **14.07.2004**
(21) Numéro de dépôt: 98402501.5
(22) Date de dépôt: 08.10.1998
(51) Int. Cl.: G06K 19/077

(54) **Carte à microcircuit et procédé de fabrication d'une telle carte**
IC Karte und Verfahren zum Herstellen einer solchen Karte
IC card and manufacturing method of such a card

(30) Priorité: 10.10.1997 FR 9712665
(43) Date de publication de la demande: 12.05.1999
(73) Titulaire: DE LA RUE CARTES ET SYSTEMES, 75013 Paris (FR)
(72) Inventeur: Launay, Francois, 14610 Epron (FR); Van Leusden, Bernardus, 14000 Caen (FR)
(74) Mandataire: Santarelli

(56) Documents cités:
- EP-A- 0 071 031
- EP-A- 0 688 051

## Description

L'invention se rapport à une carte à microcircuit du type comprenant un tel microcircuit inséré dans une cavité de la carte et électriquement connecté à une pluralité de plages de contact extérieur, métalliques. Elle concerne plus particulièrement un perfectionnement permettant d'améliorer les performances mécaniques de la carte en particulier la tenue des raccordements électriques entre le microcircuit et lesdites plages de contact extérieur, tout en offrant de nouvelles possibilités pour personnaliser la carte selon le souhait de l'éditeur.

L'invention concerne également un procédé permettant d'obtenir une telle carte à microcircuit et un outillage pour la mise en oeuvre d'un tel procédé.

Les cartes à microcircuit, couramment dénommées « cartes à puce » se développent rapidement dans de nombreux domaines tels que le domaine bancaire, le téléphone public, le téléphone portatif, les décodeurs de télévision, etc... Une telle carte comprend un microcircuit inséré dans une cavité au fond de laquelle convergent un certain nombre de pistes métalliques raccordées à des plages de contact extérieur, métalliques, disposées sur une face de la carte (antérieurement, on connaissait, par exemple d'après le document EP-A-0 071 031, des cartes dont la cavité contenait une pastille portant à la fois le microcircuit et les plages de contact extérieur). Ces plages de contact extérieur permettent le raccordement électrique du microcircuit à un terminal dans lequel la carte peut être insérée. La fiabilité d'une telle carte dépend grandement de la qualité des contacts électriques entre le microcircuit et les pistes métalliques reliées aux plages de contact extérieur. Comme la carte est relativement mince et flexible, il est impératif que ces contacts ne soient pas rompus par une flexion de la carte, notamment au voisinage de la cavité.

L'invention permet notamment d'augmenter la fiabilité de la carte, toutes choses égales par ailleurs, en augmentant localement, c'est-à-dire au voisinage de la cavité, sa résistance à la flexion.

Plus précisément, l'invention concerne donc une carte à microcircuit du type comprenant un tel microcircuit inséré dans une cavité de ladite carte et électriquement connecté à une pluralité de plages de contact extérieur, métalliques, disposées sur une face de la carte dans une zone de raccordement définie à proximité immédiate et à l'extérieur de ladite cavité, caractérisée en ce que la carte comporte au moins une plage métallique supplémentaire s'étendant au-delà de ladite zone de raccordement, la ou l'ensemble des plages métalliques supplémentaires entourant au moins en partie ladite zone de raccordement.

On entend par zone de raccordement, une zone où doivent être regroupées les plages de contact extérieur au voisinage de la cavité, en des emplacements prédéfinis et sur des surfaces minimales prédéterminées pour assurer la compatibilité de la carte avec tous les lecteurs auxquels elle est susceptible d'être raccordée. Actuellement, la configuration de ces plages de contact extérieur doit répondre à une norme (norme ISO 7816-2) ; par conséquent, la zone de raccordement définie plus haut peut facilement se déduire de cette norme.

Plus précisément, la norme en question définit les positions et les dimensions minimales de ces plages. Il est usuel de donner à ces plages des dimensions sensiblement supérieures aux valeurs minimales imposées, par exemple de l'ordre de 30 % en plus. Par conséquent, une zone de raccordement selon l'acception donnée ici, pourra être une surface sensiblement centrée par rapport au centre de la cavité et d'étendue juste suffisante pour contenir toutes les plages de contact extérieur ainsi agrandies. Actuellement, les cartes sont classiquement équipées d'une "vignette" d'aspect doré et de forme oblongue ou rectangulaire de 15 x 12 mm environ. Une telle vignette peut être considérée comme définissant une zone de raccordement précitée. En d'autres termes, l'invention est remarquable en ce qu'une ou plusieurs plages métalliques supplémentaires s'étendant au-delà de cette zone de raccordement et suivant une configuration entourant au moins partiellement cette zone, se trouvent déposées ou incrustées à la surface de la carte. On a en effet constaté que le fait de déposer des plages métalliques non directement utiles au raccordement électrique mais entourant ladite zone de raccordement (au centre de laquelle se trouve la cavité et le microcircuit), entraîne une rigidification locale de la carte, améliorant la tenue dans le temps des contacts électriques entre le microcircuit et les plages de raccordement extérieur, ceci en dépit des flexions ou autres sollicitations que peut subir la carte pendant sa durée d'utilisation.

Par ailleurs, la présence d'une telle plage métallique supplémentaire ou de plusieurs plages définissant ensemble une configuration entourant sensiblement la zone de raccordement, permet d'obtenir une personnalisation plus marquée de la carte, permettant à l'utilisateur de reconnaître plus rapidement, parmi l'ensemble des cartes dont il dispose dans son portefeuille, celle qui correspond au service dont il désire bénéficier à un moment donné.

Pour ce faire, on donne à la ou à l'ensemble des plages métalliques supplémentaires une configuration particulière définissant au moins une partie d'un dessin identifiant, d'aspect métallique. De préférence la métallisation est la même que celle des plages de contact extérieur ; le plus souvent, les plages métalliques comportent une fine couche d'or. L'ensemble attire donc l'attention plus que tout autre détail imprimé sur la carte et par conséquent, le dessin d'aspect métallique est très rapidement identifié par le possesseur de la carte comme représentatif de l'éditeur de celle-ci, donc d'un service particulier.

Dans la pratique, plusieurs plages métalliques supplémentaires peuvent prolonger des plages de contact extérieur différentes, voire être confondues avec elles. Dans ce cas, il est avantageux que de telles plages métalliques supplémentaires adjacentes soient séparées par des bords au moins approximativement parallèles à une direction d'insertion de la carte, afin d'éviter tout risque de court-circuit, lors de son raccordement à certains types de lecteurs.

L'invention concerne également un procédé de fabrication de carte à microcircuit, une telle carte comprenant une cavité apte à recevoir un tel microcircuit et une pluralité de plages de contact extérieur métalliques disposées sur une face de la carte dans une zone de raccordement définie à proximité immédiate et à l'extérieur de la cavité, caractérisé en ce qu'il consiste à rapporter sur la carte, autour de ladite zone de raccordement, au moins une plage métallique supplémentaire.

Avantageusement, une ou plusieurs plages métalliques supplémentaires sont rapportées en une même opération ou série d'opérations et, si la technologie de réalisation des plages de contact extérieur le permet, on peut aussi rapporter les plages de contact extérieur et/ou des prolongements de celles-ci s'étendant dans la cavité par ladite même opération ou série d'opérations.

De préférence, on pourra utiliser une technique d'estampage à chaud, connue en soi. Une telle technique a été décrite notamment dans le document de brevet européen publié sous le N° 0 688 051. D'autres techniques telles que la tampographie suivie d'une métallisation par autocatalyse ou la photolithographie avec mise au point par masque 3D ou hologramme laser, peuvent aussi être utilisées avec succès. Ces deux autres techniques sont également mentionnées dans le document identifié ci-dessus.

Dans le cas actuellement préféré de la mise en oeuvre de l'estampage à chaud pour obtenir la configuration souhaitée des plages métalliques, un outillage permettant la mise en oeuvre du procédé en question est caractérisé en ce qu'il comporte un outil d'estampage à chaud présentant des surfaces ayant la forme d'au moins une ou plusieurs plages métalliques supplémentaires précitées et des surfaces ayant la forme de plages de contact extérieur et de leurs prolongements s'étendant jusque dans ladite cavité. Il est bien entendu que les surfaces de telles plages de contact extérieur peuvent être entièrement confondues (d'un seul tenant) avec la surface d'une plage métallique supplémentaire correspondante.

L'invention sera mieux comprise et d'autres avantages de celle-ci apparaîtront plus clairement à la lumière de la description qui va suivre, donnée uniquement à titre d'exemple et faite en référence aux dessins annexés dans lesquels:
- la figure 1 est une vue de dessus d'une carte à microcircuit conforme à l'invention;
- la figure 2 est une vue en perspective d'un outil permettant de mettre en oeuvre le procédé conforme à l'invention;
- la figure 3 est une vue schématique de détail décrivant une feuille métallique composite plus particulièrement utilisable pour la mise en oeuvre de l'invention; et
- les figures 4a, 4b et 4c sont des vues schématiques illustrant la mise en oeuvre du procédé.

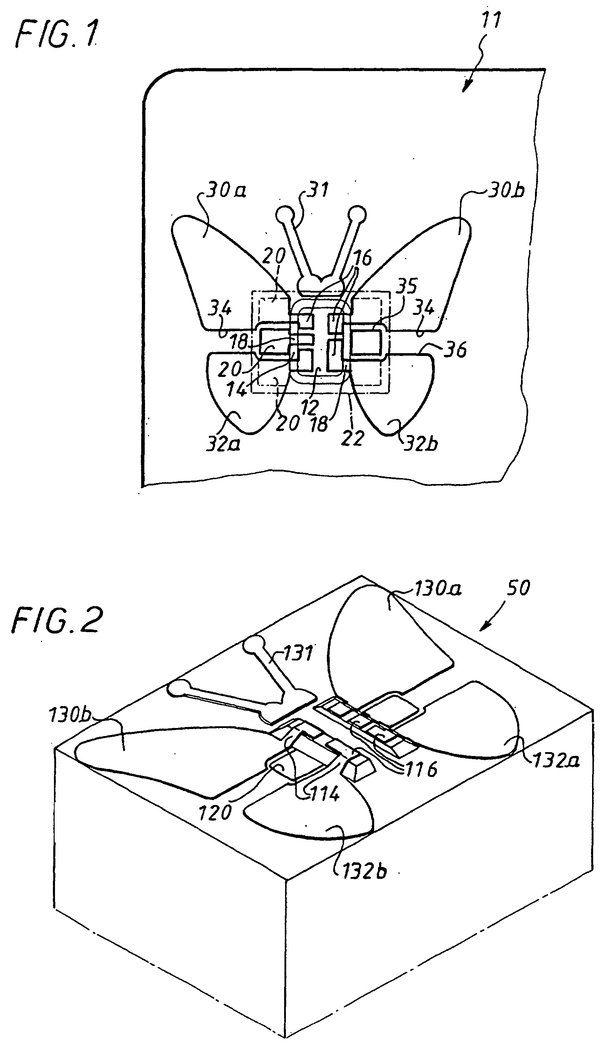

La figure 1 représente une partie d'une carte à microcircuit 11 conforme à l'invention, ledit microcircuit n'étant pas représenté dans sa cavité 12, pour une meilleure visualisation des éléments caractéristiques de l'invention.

Plus précisément, le microcircuit est destiné à être monté au fond d'une telle cavité 12 présentant des flancs inclinés 14. Des bornes de raccordement métalliques 16 sont disposées au fond de la cavité, elles sont prolongées par des pistes conductrices 18 qui s'étendent sur les flancs de ladite cavité et établissent la liaison avec des plages de contact extérieur 20 disposées sur une face de la carte dans une zone de raccordement définie à proximité immédiate de la cavité. Une telle zone de raccordement 22 peut se déduire de la norme définie ci-dessus ; elle est indiquée à titre d'exemple par un rectangle en trait mixte sur la figure 1.

Comme on le voit, certaines plages de contact extérieur 20 ne sont pas dissociables d'autres parties métalliques plus étendues ; elles sont néanmoins visualisées en trait interrompu. Les bornes de raccordement 16, les pistes de liaison 18 et les plages de contact extérieur 20 sont issues d'une même feuille métallique composite 24 représentée à la figure 2. Une telle feuille est composée d'au moins une couche d'un agent d'adhérence 25 (par exemple une colle époxy ou polyamide) d'une épaisseur de 1 à 4 microns, d'une couche de cuivre 26 relativement ductile, d'épaisseur comprise entre 12 et 35 microns, d'une couche de nickel 27 d'épaisseur comprise entre 1 et 2 microns et d'un mince dépôt d'or ou d'argent-palladium 28. Cette structure métallique composite est adaptée à la mise en oeuvre d'un processus d'estampage à chaud permettant de rapporter sur la carte toutes les parties métalliques en une même opération ou série d'opérations. Le processus d'estampage à chaud aboutissant à l'élaboration des parties métalliques représentées sur la figure 1 sera décrit ci-dessous.

Selon une caractéristique remarquable de l'invention, la carte comporte au moins une plage métallique supplémentaire, en l'occurrence ici plusieurs plages métalliques 30a, 30b 31, 32a, 32b, provenant de la même feuille métallique composite, s'étendant au-delà de la zone de raccordement 22.

Comme cela est visible, l'ensemble des plages métalliques supplémentaires entoure en grande partie la zone de raccordement 22. S'il n'y avait qu'une seule plage métallique supplémentaire, celle-ci encerclerait au moins en grande partie ladite zone de raccordement renfermant toutes les plages de contact extérieur 20. Autrement dit, cette métallisation autour de la cavité 12 a pour conséquence de rigidifier quelque peu la carte localement et, par conséquent, d'améliorer la fiabilité des contacts électriques entre le microcircuit (non représenté) et les bornes de connexion 16 convergeant au fond de la cavité et de réduire les contraintes au niveau du microcircuit lors des flexions subies par la carte.

Comme cela est visible sur la figure 1, plusieurs plages métalliques supplémentaires 30a, 30b, 31a, 31b sont dans le prolongement de plages de contact extérieur 20 respectives et se confondent même avec elles. Pour éviter de possibles anomalies de fonctionnement en liaison avec certains lecteurs de carte, de telles plages de contact extérieur et/ou plages métalliques supplémentaires adjacentes sont séparées par des bords 34, 35, 36 au moins approximativement parallèles à la direction d'insertion de la carte indiquée par la flèche F sur la figure 1.

Selon une caractéristique avantageuse, la ou l'ensemble des plages métalliques supplémentaires définit au moins une partie d'un dessin identifiant d'aspect entièrement métallique. Par dessin identifiant, on entend toute silhouette figurative ou abstraite représentative de l'éditeur de la carte pour l'utilisateur. Dans l'exemple, ce dessin est celui d'un papillon, des ailes de ce papillon étant confondues avec certaines plages de contact extérieur.

Après montage du microcircuit dans la cavité, il est usuel de remplir la cavité de résine. Avantageusement, cette résine peut être colorée ou chargée en particules de couleur or, d'un ton aussi proche que possible de celui des parties métalliques voisines. Dans l'exemple, le remplissage de la cavité aura pour conséquence d'achever la représentation du corps du papillon. On peut par exemple utiliser des poudres commercialisées actuellement par la firme MERCK sous la dénomination "IRIODIN 320" et "IRIODIN 323".

Bien entendu, dans d'autres configurations, on peut rapporter séparément les parties métalliques correspondant aux plages de contact extérieur et les parties métalliques correspondant à la ou les plages métalliques supplémentaires. Cette variante s'applique si le microcircuit est d'abord intégré à un insert comportant en outre les plages de contact extérieur métalliques, ledit insert étant ensuite fixé dans une cavité de forme et dimensions correspondantes.

L'outil d'estampage à chaud 50, susceptible de réaliser les métallisations de la figure 1, est représenté sur la figure 2. On y reconnaît des zones 116 destinées à définir les bornes de connexion 16, des zones inclinées 114 destinées à définir les pistes de liaison 18 et enfin, des zones plus étendues, dans un même plan, destinées à définir à la fois les plages de contact extérieur 120 et la ou les plages métalliques supplémentaires 130a, 130b, 131, 132a, 132b . Si l'étampage à chaud ne concerne que la formation desdites plages métalliques supplémentaires, l'outil est conformé en conséquence et ne comporte que des surfaces ayant la forme de ces plages métalliques supplémentaires. Si l'estampage à chaud concerne la formation de toutes les parties métalliques (ce qui est le cas représenté), l'outil présente à la fois des surfaces ayant la forme d'une ou plusieurs plages métalliques supplémentaires précitées et aussi des surfaces ayant la forme de plages de contact extérieur (éventuellement confondues avec certaines plages métalliques supplémentaires) et de leur prolongement s'étendant jusque dans la cavité 22, c'est-à-dire les pistes et bornes de connexion.

L'estampage à chaud, actuellement préféré, consiste à utiliser une feuille métallique composite dont la couche de cuivre présente certaines caractéristiques décrites par exemple dans le brevet européen N° 0 063 347. On utilise un matériau principalement en cuivre dont la résistance au cisaillement a une valeur assez faible pour que les parties imprimées à chaud, c'est-à-dire en contact avec les parties correspondantes de l'outil 50 convenablement chauffé, se détachent des autres parties non imprimées suivant une séparation à bords nets, et restent fixées à la carte en raison de la réactivation thermique de l'agent d'adhérence.

A titre d'exemple, on peut obtenir de bons résultats avec un cuivre (couche 26) présentant un coefficient d'élongation de 490 N/mm² et un module d'Young de 60000 N/mm².

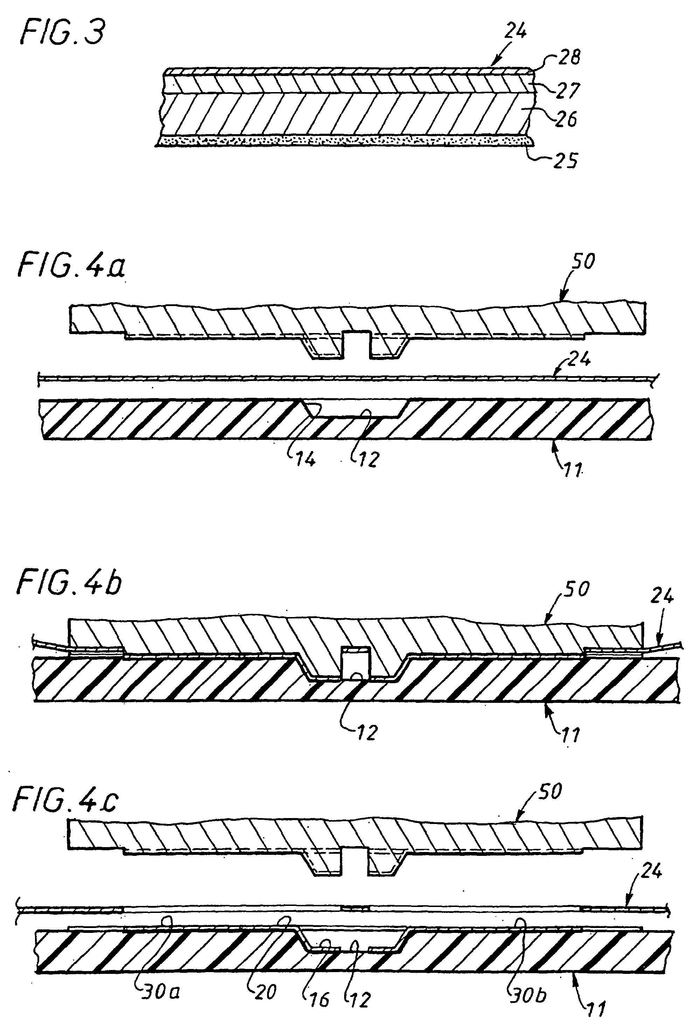

Les figures 4a à 4c illustrent les opérations d'estampage à chaud. Les paramètres à prendre en considération sont plus particulièrement la température de l'outil 50, le temps de cycle et la pression. Ils dépendent du matériau constituant la carte. Ainsi, de bons résultats ont été obtenus avec une carte en matériau du type "PC-ABS" (composé polycarbonate-acrylonitrile/butadiène/styrène) avec une température de 160° C, un temps de cycle de 1,5 seconde et une pression de 10 N/mm². Pour d'autres matériaux tels que le "PVC" (polychlorure de vinyle) la température doit être plus faible, de l'ordre 120 à 130° C.

Sur la figure 4a, une feuille 24, sous forme d'un film, est interposée entre l'outil 50 chauffé à bonne température et la carte 11.

A la figure 4b, l'outil 50 est abaissé pour appliquer le film métallique dans la cavité 12 et à la surface supérieure de la carte 11. Au cours de cette opération, les parties non chauffées se séparent des parties chauffées.

A la figure 4c, l'outil 50 est éloigné de la carte 11 et les parties du film métallique 34 qui n'ont pas été chauffées et fixées à la carte, sont éliminées. Elles peuvent par exemple être retirées à partir d'une station d'enroulement à ruban adhésif.

Après estampage, d'éventuelles surépaisseurs de matière plastique au bord des parties métallisées, peuvent être aplaties à l'aide d'un outil plat épousant la forme de la cavité et de son contour.

Le procédé d'estampage à chaud qui vient d'être décrit est actuellement préféré pour l'obtention desdites plages métalliques supplémentaires, de préférence conjointement à la formation des plages de contact extérieur et de leurs prolongements dans la cavité. Cependant, on peut envisager d'autres procédés.

Une autre technique connue et applicable est la tampographie suivie d'une métallisation par autocatalyse. Une laque contenant du palladium peut être imprimée sur la carte, contre les parois et le fond de la cavité. Cette laque constitue un catalyseur lorsqu'elle est chauffée à environ 100° C. On procède alors à une métallisation par autocatalyse, le cuivre ne se déposant qu'aux endroits où le catalyseur est présent.

Il est aussi possible d'utiliser un procédé de photolithographie et, dans le cas où la métallisation doit être effectuée sur les côtés et au fond de la cavité, on peut mettre en oeuvre une technique de photolithographie 3D. Pour cela, on utilise une technique connue de mise au point par masque 3D ou hologramme laser. Cette technique consiste à réaliser l'image des parties à métalliser en trois dimensions, ce qui permet d'obtenir la polymérisation d'un vernis seulement aux endroits voulus sur la surface de la carte et à l'intérieur de la cavité.

## Revendications

1. Carte à microcircuit du type comprenant un tel microcircuit inséré dans une cavité (12) de ladite carte et électriquement connecté à une pluralité de plages de contact extérieur métalliques (20) disposées sur une face de la carte dans une zone de raccordement (22) défini à proximité immédiate et à l'extérieur de ladite cavité **caractérisée en ce que** la carte comporte au moins une plage métallique supplémentaire (30a, 30b, 31, 32a, 32b) s'étendant au-delà de ladite zone de raccordement (22), la où l'ensemble des plages métalliques supplémentaires entourant au moins en partie ladite zone de raccordement (22).

2. Carte à microcircuit selon la revendication 1, **caractérisée en ce qu'**au moins une telle plage métallique supplémentaire (30a, 30b, 32a, 32b) est dans le prolongement de l'une des plages de contact extérieur (20) précitées.

3. Carte à microcircuit selon la revendication 2, **caractérisée en ce qu'**au moins une plage de contact extérieur (20) se confond avec une telle plage métallique supplémentaire qui la prolonge.

4. Carte à microcircuit selon la revendication 2 ou 3, dans laquelle plusieurs des plages métalliques supplémentaires prolongent ou sont confondues avec des plages de contact extérieur différentes, **caractérisée en ce que** de telles plages métalliques supplémentaires adjacentes sont séparées par des bords (34, 35, 36) au moins approximativement parallèles à une direction d'insertion (F) de la carte.

5. Carte à microcircuit selon l'une des revendications précédentes, **caractérisée en ce que** la ou l'ensemble des plages métalliques supplémentaires définissent au moins une partie d'un dessin identifiant, d'aspect métallique.

6. Procédé de fabrication de carte à microcircuit, une telle carte comprenant une cavité (12) apte à recevoir un tel microcircuit et une pluralité de plages de contact extérieur (20) métalliques disposées sur une face de la carte dans une zone de raccordement (22) définie à proximité immédiate et à l'extérieur de la cavité, **caractérisé en ce qu'**il consiste à rapporter sur la carte, autour de ladite zone de raccordement (22), au moins une plage métallique supplémentaire (30a, 30b, 31, 32a, 32b).

7. Procédé selon la revendication 6, **caractérisé en ce qu'**il consiste à rapporter la ou plusieurs plages métalliques supplémentaires en une même opération ou série d'opérations.

8. Procédé selon la revendication 7, **caractérisé en ce qu'**il consiste en outre à rapporter les plages de contact extérieur (16) et/ou des prolongements de celles-ci s'étendant dans la cavité, par ladite même opération ou série d'opérations.

9. Procédé selon la revendication 7 ou 8, **caractérisé en ce qu'**on met en oeuvre une technique d'estampage à chaud, connue en soi.

10. Procédé selon la revendication 7 ou 8, **caractérisé en ce qu'**on met en oeuvre une technique de tampographie suivie d'une métallisation par autocatalyse, connue en soi.

11. Procédé selon la revendication 7 ou 8, **caractérisé en ce qu'**on met en oeuvre une technique de photolithographie, de préférence avec mise au point par masque 3D ou hologramme laser.

12. Outillage pour la mise en oeuvre du procédé selon la revendication 9, **caractérisé en ce qu'**il comporte un outil d'estampage à chaud (50) présentant des surfaces (130a, 130b, 131, 132a, 132b) ayant la forme d'au moins une ou plusieurs plages métalliques supplémentaires précitées et des surfaces (120) ayant la forme de plages de contact extérieur et de leurs prolongements s'étendant jusque dans ladite cavité.

## Patentansprüche

1. IC-Karte bzw. Mikroschaltungskarte des Typs, umfassend eine in einen Hohlraum (12) der Karte eingesetzte und elektrisch mit einer Mehrzahl von äußeren metallischen Anschlußbereichen (20) verbundene Mikroschaltung, die auf einer Seite der Karte in einem Verbindungsbereich (22) angeordnet sind, der in der unmittelbaren Nachbarschaft und außerhalb des Hohlraums definiert ist, **dadurch gekennzeichnet, daß** die Karte wenigstens einen zusätzlichen, metallischen Bereich (30a, 30b, 31, 32a, 32b) umfaßt, der sich über den Verbindungsbereich (22) erstreckt, wobei der oder die Gesamtheit der zusätzliche(n), metallische(n) Bereich(e) wenigstens den Verbindungsbereich (22) umgibt (umgeben).

2. IC-Karte nach Anspruch 1, **dadurch gekennzeichnet, daß** sich wenigstens ein derartiger, zusätzlicher, metallischer Bereich (30a, 30b, 32a, 32b) in der Verlängerung von einem der vorgenannten äußeren Kontaktbereiche (20) befindet.

3. IC-Karte nach Anspruch 2, **dadurch gekennzeichnet, daß** wenigstens einer der äußeren Kontaktbereiche (20) mit einem derartigen zusätzlichen, metallischen Bereich zusammenfällt, welcher ihn fortsetzt bzw. verlängert.

4. IC-Karte nach Anspruch 2 oder 3, in welcher mehrere zusätzliche, metallische Bereiche unterschiedliche, äußere Kontaktbereiche verlängern oder mit diesen zusammenfallen bzw. übergehen bzw. verwechseln, **dadurch gekennzeichnet, daß** die benachbarten, zusätzlichen, metallischen Bereiche durch Ränder (34, 35, 36) getrennt sind, die wenigstens etwa parallel zu einer Einsetz- bzw. Einführrichtung (F) der Karte sind.

5. IC-Karte nach einem der vorhergehenden Ansprüche, **dadurch gekennzeichnet, daß** der oder die Gesamtheit der zusätzliche(n), metallische(n) Bereich(e) wenigstens einen Teil eines identifizierenden Designs bzw. Musters mit metallischem Aussehen definiert(en).

6. Herstellungsverfahren einer IC-Karte bzw. Mikroschaltungskarte, wobei eine derartige Karte einen Hohlraum (12) umfaßt, der fähig ist, eine derartige Mikroschaltung und eine Mehrzahl von metallischen äußeren Kontaktbereichen (20) aufzunehmen, die auf einer Seite der Karte in einem Verbindungsbereich (22) vorgesehen sind, der in unmittelbarer Nachbarschaft und außerhalb des Hohlraums definiert ist, **dadurch gekennzeichnet, daß** es darin besteht, auf der Karte um den Verbindungsbereich (22) wenigstens einen zusätzlichen, metallischen Bereich (30a, 30b, 31, 32a, 32b) aufzubringen.

7. Verfahren nach Anspruch 6, **dadurch gekennzeichnet, daß** es in einem Aufbringen des oder von mehreren zusätzlichen, metallischen Bereichs(en) in ein und demselben Vorgang oder einer Serie von Vorgängen besteht.

8. Verfahren nach Anspruch 7, **dadurch gekennzeichnet, daß** es darüber hinaus in einem Aufbringen der äußeren Kontaktbereiche (16) und/oder von Verlängerungen derselben, die sich in den Hohlraum erstrecken, durch den genannten, gleichen Vorgang oder Serie von Vorgängen besteht.

9. Verfahren nach Anspruch 7 oder 8, **dadurch gekennzeichnet, daß** eine an sich bekannte Heißstanztechnik eingesetzt wird.

10. Verfahren nach Anspruch 7 oder 8, **dadurch gekennzeichnet, daß** eine Tampographietechnik, gefolgt von einer Metallisierung durch Autokatalyse, welche an sich bekannt sind, angewandt wird.

11. Verfahren nach Anspruch 7 oder 8, **dadurch gekennzeichnet, daß** eine Photolithographietechnik, vorzugsweise mit 3D-Maskierung oder Hologrammlaser durchgeführt wird.

12. Werkzeug für die Durchführung des Verfahrens nach Anspruch 9, **dadurch gekennzeichnet, daß** es ein Heißstanzwerkzeug (50) umfaßt, das Flächen bzw. Oberflächen (130a, 130b, 131, 132a, 132b), die die Form von wenigstens einem oder mehreren vorgenannten, zusätzlichen, metallischen Bereich(e) aufweisen, und Flächen bzw. Oberflächen (120) aufweist, die die Form von äußeren Kontaktanschlüssen und ihren Verlängerungen aufweisen, die sich in den Hohlraum erstrecken.

## Claims

1. Microcircuit card of the type comprising a microcircuit inserted in a cavity (12) in said card and electrically connected to a plurality of metallic external contact areas (20) disposed on a face of the card in a connection area (22) defined in the immediate vicinity of and outside said cavity, **characterized in that** the card comprises at least one supplementary metal area (30a, 30b, 31, 32a, 32b) extending beyond said connection area (22), the or all of the supplementary metallic areas surrounding at least in part said connection area (22).

2. A microcircuit card according to claim 1, **characterized in that** at least one such supplementary metallic area (30a, 30b, 32a, 32b) extends one of the external contact areas (20) previously cited.

3. A microcircuit card according to claim 2, **characterized in that** at least one external contact area (20) is integral with one such supplementary metallic area that extends it.

4. Microcircuit card according to claim 2 or 3, wherein a plurality of the supplementary metallic areas extends or is integral with different external contact areas, **characterized in that** such adjacent supplementary metal areas are separated by edges (34, 35, 36) at least approximately parallel to a direction (F) of insertion of the card.

5. Microcircuit card according to any of the preceding claims, **characterized in that** the supplementary metallic area or the set of supplementary metallic areas defines at least one portion of an identifying design of metallic appearance.

6. A method of fabricating a microcircuit card, such a card comprising a cavity (12) adapted to receive a microcircuit and a plurality of metallic external contact areas (20) disposed on a face of the card in a connection area (22) defined in the immediate vicinity of and outside the cavity, **characterized in that** it consists in attaching to the card, around said connection area (22), at least one supplementary metallic area (30a, 30b, 31, 32a, 32b).

7. Method according to claim 6, **characterized in that** it consists in attaching the supplementary metallic area or plurality of supplementary metallic areas in the same operation or series of operations.

8. Method according to claim 7, **characterized in that** it further consists in attaching the exterior contact areas (16) and/or extensions thereof extending into the cavity by said same operation or series of operations.

9. Method according to claim 7 or 8, **characterized in that** it uses a prior art hot stamping technique.

10. Method according to claim 7 or 8, **characterized in that** it uses a prior art technique of tampography followed by metallization by autocatalysis.

11. Method according to claim 7 or 8, **characterized in that** it uses a photolithography technique, preferably with focussing by 3D mask or laser hologram.

12. Tooling for implementing the method according to claim 9, **characterized in that** it comprises a hot stamping tool (50) having surfaces (130a, 130b, 131, 132a, 132b) having the shape of at least one or a plurality of the supplementary metallic areas previously cited and surfaces (120) having the shape of external contact areas and their extensions extending into said cavity.
